# FASCICULE DE BREVET EUROPEEN

(11) **EP 3 401 953 B1**
(45) Date de publication et mention de la délivrance du brevet: **18.02.2026**
(21) Numéro de dépôt: 18170907.2
(22) Date de dépôt: 04.05.2018
(51) Int. Cl.: H01L 21/762, H10D 86/01, H10D 30/69, H10D 89/10, H10D 86/00, H10D 84/01, H10D 84/03, H10D 84/85

(54) **PUCE À TRANSISTORS NMOS ET PMOS CONTRAINTS**
CHIP MIT VERSPANNTEN NMOS- UND PMOS-TRANSISTOREN
CHIP WITH STRAINED NMOS AND PMOS TRANSISTORS

(30) Priorité: 12.05.2017 FR 1754199
(43) Date de publication de la demande: 14.11.2018
(73) Titulaire: Commissariat à l'Energie Atomique et aux Energies Alternatives, 75015 Paris (FR); STMicroelectronics (Crolles 2) SAS, 38920 Crolles (FR)
(72) Inventeur: BERTHELON, Rémy, 38400 SAINT MARTIN D'HERES (FR); ANDRIEU, François, 38330 SAINT ISMIER (FR)
(74) Mandataire: Cabinet Beaumont

(56) Documents cités:
- US-A1- 2007 262 392
- US-A1- 2011 092 047
- US-A1- 2011 175 164
- US-A1- 2016 086 803
- US-B1- 7 700 416

## Description

### Domaine

La présente demande concerne le domaine de la fabrication de transistors, en particulier d'une puce à transistors MOS à canal contraint de type N et de type P.

### Exposé de l'art antérieur

Les performances de certains types de transistors MOS, notamment sur structure de type semiconducteur sur isolant SOI, peuvent être améliorées par la présence de contraintes dans la région de canal.

Le fonctionnement d'un transistor à canal P orienté dans le sens cristallin <110> est accéléré lorsque sa région de canal est contrainte en compression dans la direction de la longueur de grille, c'est-à-dire le sens drain-source ou sens longitudinal. Un tel transistor à canal P est en outre accéléré lorsque sa région de canal est contrainte en tension dans le sens transversal. Le fonctionnement d'un transistor à canal N orienté dans le sens cristallin <110> est accéléré lorsque sa région de canal est contrainte en tension longitudinale, les contraintes transversales n'ayant pas d'effet notable. Ainsi, pour les transistors à canal N et à canal P, il est souhaitable de prévoir des contraintes longitudinales opposées, respectivement en tension et en compression.

Les procédés connus pour réaliser simultanément des transistors à canal P et à canal N présentent divers inconvénients, notamment ils sont difficilement compatibles avec la coexistence de contraintes différentes pour les types de canal N et P, en particulier dans le cas de transistors de très petites dimensions transversales et longitudinales, par exemple inférieures à 500 nm.

Les documents US7700416 et US2011/175164, ainsi que les documents US2007/262392, US2011/092047 et US2016/086803 décrivent des exemples de puces comprenant des transistors à canal N et à canal P contraints différemment. En particulier, le document US7700416 décrit l'utilisation d'une couche sacrificielle contrainte en compression pour créer une couche de surface de type SOI (silicium sur isolant) avec une contrainte en tension, à l'aide d'une relaxation aux bords par la formation de tranchées.

### Résumé

L'invention prévoit de pallier tout ou partie des inconvénients décrits ci-dessus.

Ainsi, l'invention prévoit un procédé de fabrication simultanée de transistors MOS à canal N et à canal P contraints différemment et situés respectivement dans des première et deuxième bandes côte à côte, le procédé comprenant les étapes a), b), c) et d) telles qu'elles sont spécifiées dans la revendication 1.

Selon un mode de réalisation, le procédé comprend, à l'étape d), former des grilles isolées sur les portions du ruban en regard des tranchées transversales ; relier les transistors à une source de potentiels haut et bas d'alimentation ; et relier lesdites grilles isolées à un noeud d'application du potentiel haut d'alimentation.

Selon un mode de réalisation, la couche isolante est en oxyde de silicium, et la couche contrainte est en nitrure de silicium formé à l'étape a) par dépôt chimique en phase vapeur assisté par plasma, le procédé comprenant, après les étapes b) et c) :
effectuer un traitement thermique de relaxation de la couche contrainte adapté à conserver au moins en partie les contraintes du ruban et des dalles ; et
retirer la couche contrainte.

Selon un mode de réalisation, le substrat est en silicium ; et la couche contrainte est en silicium-germanium et est épitaxiée à l'étape a) sur le substrat avant de former l'ensemble des couches isolante et semiconductrice sur la couche contrainte.

Selon un mode de réalisation, les étapes b) et c) sont réalisées simultanément et les tranchées transversales et longitudinales ont la même profondeur.

Selon un mode de réalisation, le procédé comprend une étape de formation d'un caisson semiconducteur dopé sous la couche isolante dans la première bande, les tranchées longitudinales s'étendant plus profondément que le caisson, et les tranchées transversales s'étendant jusqu'à un niveau situé dans le caisson.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
les figures 1A à 1D représentent, de manière partielle et schématique, une puce comprenant des transistors à canal N et à canal P ;
les figures 2A à 2D, 3A à 3D, 4A à 4D, 5A à 5D, et 6A à 6D illustrent schématiquement des étapes d'un mode de réalisation, non revendiqué, d'un procédé de fabrication simultanée de transistors à canal N et à canal P contraints différemment ;
les figures 7A à 7D et 8A à 8D illustrent schématiquement des étapes d'un autre mode de réalisation d'un procédé de fabrication simultanée de transistors à canal N et à canal P contraints différemment ;
les figures 9A à 9D, 10A à 10D, et 11A à 11D illustrent schématiquement des étapes d'un autre mode de réalisation, non revendiqué, d'un procédé de fabrication simultanée de transistors à canal N et à canal P contraints différemment ;
les figures 12A à 12D illustrent schématiquement une étape d'un autre mode de réalisation, non revendiqué, d'un procédé de fabrication simultanée de transistors à canal N et à canal P contraints différemment ; et
les figures 13A à 13D illustrent schématiquement une étape d'un autre mode de réalisation, non revendiqué, d'un procédé de fabrication simultanée de transistors à canal N et à canal P contraints différemment.

### Description détaillée

De mêmes éléments ont été désignés par de mêmes références dans les différentes figures et, de plus, les diverses figures ne sont pas tracées à l'échelle. Par souci de clarté, seuls les éléments utiles à la compréhension des modes de réalisation décrits ont été représentés et sont détaillés. En particulier, des circuits formés de transistors ne sont pas décrits ou représentés en détail, et des détails de certaines étapes, tels que la formation et le retrait de couches de masquage, ne sont ni décrits ni représentés, ces détails pouvant être déduits par l'homme de métier à partir des indications de la présente description.

Dans la description qui suit, lorsque l'on fait référence à des qualificatifs de position, tels que les termes "gauche", "droite" et "supérieur", il est fait référence à l'orientation de l'élément concerné dans les vues en coupe.

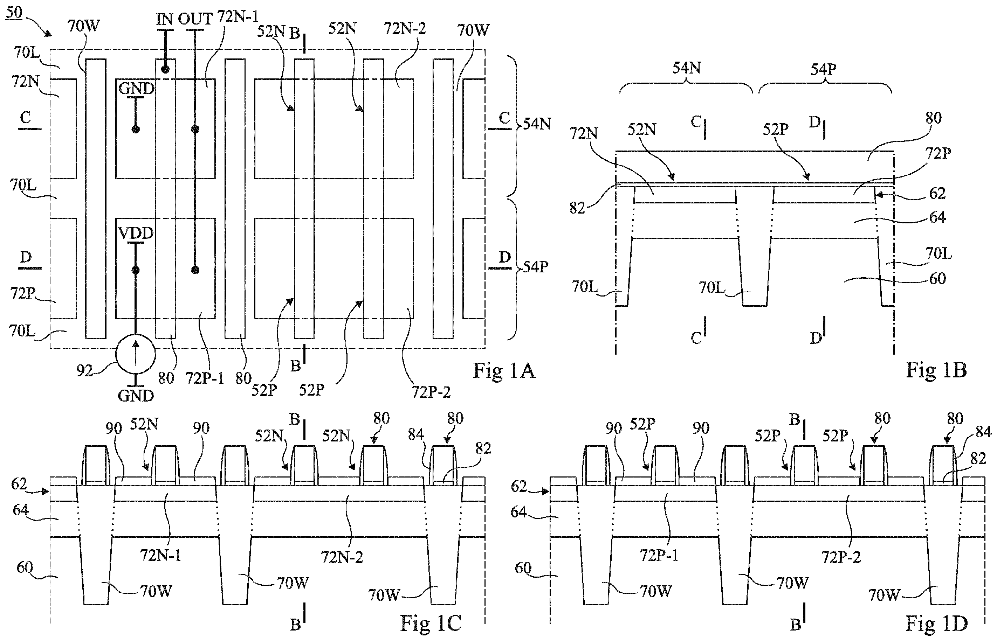

Les figures 1A à 1D représentent schématiquement une partie d'une puce 50. La figure 1A est une vue de dessus, la figure 1B est une vue en coupe transversale (plan B-B), et les figures 1C et 1D sont des vues en coupe longitudinale (plans C-C et D-D). Des transistors 52N et des transistors 52P sont situés en vue de dessus respectivement dans des bandes 54N et 54P côte à côte qui s'étendent longitudinalement, le plan de coupe C-C de la figure 1C passant par les transistors 52N et le plan de coupe D-D de la figure 1D passant par les transistors 52P. A titre d'exemple, trois transistors sont représentés dans chaque bande.

La puce comprend une structure de type SOI, à savoir, sur un substrat 60, une bicouche comprenant une couche semiconductrice 62 sur une couche électriquement isolante 64. Des tranchées d'isolement 70L s'étendent longitudinalement entre les bandes 54P et 54N et de part et d'autre des bandes 54P et 54N. Des tranchées d'isolement 70W s'étendent transversalement dans les deux bandes. A partir de la face supérieure de la structure SOI, les tranchées longitudinales 70L et transversales 70W traversent les couches semiconductrice 62 et isolante 64 et s'arrêtent dans le substrat 60. Les tranchées 70L et 70W sont remplies d'un isolant électrique. Les tranchées 70L et 70W isolent ainsi, dans la couche semiconductrice 62, des dalles semiconductrices (ou zones actives) 72N dans la bande 54N et des dalles semiconductrices 72P dans la bande 54P, les dalles 72P étant disposées en regard des dalles 72N.

Des structures de grille isolée 80, comprenant un isolant de grille 82 et des espaceurs 84, sont disposées sur les dalles et s'étendent dans la direction transversale sur les deux bandes. Les structures de grille se répètent longitudinalement à un pas régulier. Les positions des tranchées transversales 70W sont prévues pour que certaines des structures de grille se trouvent sur ces tranchées sans être en contact avec les dalles. Les autres des structures de grille forment chacune les deux grilles connectées entre elles d'un transistor 52N et d'un transistor 52P en regard l'un de l'autre. A titre illustratif, on a représenté, à gauche en figures 1A, 1C et 1D, une paire de dalles 72N-1 et 72P-1 en regard, dans et sur laquelle est formé un couple de transistors 52P-52N, et, à droite, une paire de dalles 72N-2 et 72P-2 en regard, dans et sur laquelle sont formés deux couples de transistors 52P-52N. A titre d'exemple, des régions de drain-source 90 épitaxiées sont situées sur les dalles de part et d'autre des grilles.

Des circuits logiques sont formés à partir des transistors 52N et 52P en regard. Ces circuits sont alimentés, par une source d'alimentation 92, entre un potentiel haut VDD et un potentiel bas, par exemple une masse GND. A titre d'exemple, un inverseur est représenté à gauche en figure 1A entre des noeuds IN et OUT. Un autre circuit logique, non représenté, est formé à partir des transistors 52N et 52P des dalles 72N-2 et 72P-2. Ces circuits logiques voisins sont isolés par les tranchées transversales 70W.

On cherche ici à obtenir une puce dont les circuits sont plus rapides que ceux de la puce 50, ces circuits comprenant, comme ceux de la puce 50, des transistors à canal P et à canal N situés en regard dans des bandes côte à côte. Pour cela, on cherche à obtenir simultanément des transistors à canal N contraint en tension longitudinale, et à canal P contraint en compression longitudinale et/ou en tension latérale.

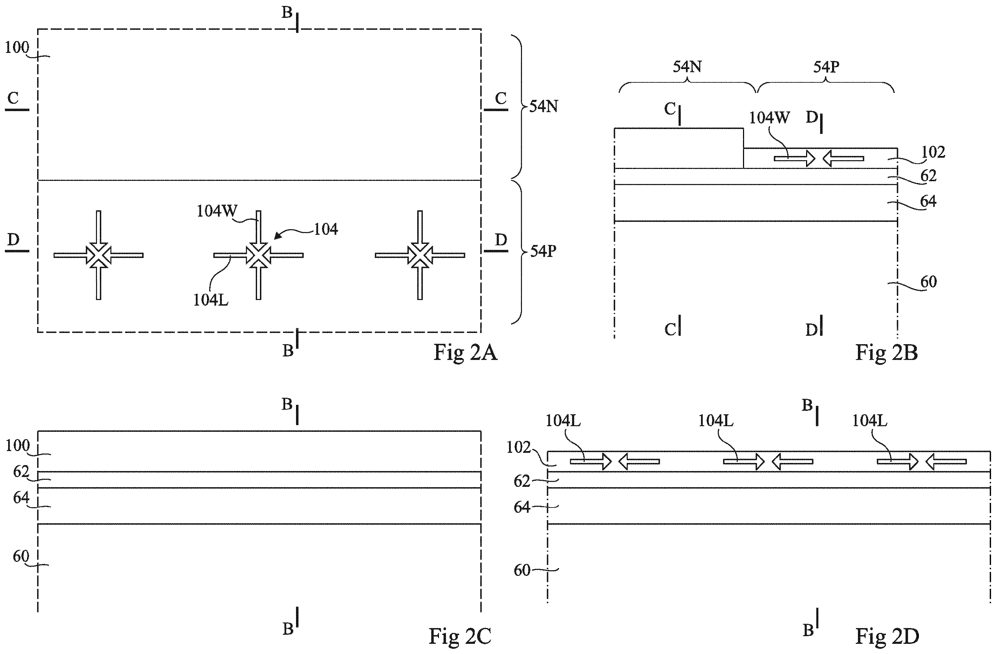

Dans la suite de la description, les figures illustrent schématiquement des étapes de divers modes de réalisation de procédés de fabrication simultanée de transistors à canal N contraint et à canal P contraint situés respectivement dans des bandes 54N et 54P côte à côte. Les figures 2A à 13A sont des vues de dessus, les figures 2B à 13B sont des vues en coupe dans un plan transversal B-B passant à l'emplacement de transistors, les figures 2C à 13C sont des vues en coupe dans un plan longitudinal C-C passant à l'emplacement de transistors à canal N, et les figures 2D à 13D sont des vues en coupe dans un plan longitudinal D-D passant à l'emplacement de transistors à canal P.

### Premier mode de réalisation, non revendiqué

Les figures 2A à 2D, 3A à 3D, 4A à 4D, 5A à 5D, et 6A à 6D illustrent schématiquement des étapes d'un premier mode de réalisation d'un procédé de fabrication simultanée de transistors à canal N et à canal P contraints différemment.

A l'étape des figures 2A à 2D, on prévoit d'abord une structure de type SOI, comprenant, sur un substrat 60 par exemple en silicium, l'ensemble d'une couche semiconductrice 62 de silicium sur une couche isolante 64, par exemple en oxyde de silicium. La structure est de préférence une structure de type FDSOI (de l'anglais "Fully Depleted Silicon On Insulator"), c'est-à-dire dans laquelle la couche semiconductrice 62 a une épaisseur comprise entre 3 et 10 nm, de préférence entre 5 et 8 nm. A titre d'exemple, la couche isolante 64 a une épaisseur comprise entre 10 et 25 nm.

Comme cela a été décrit en relation avec les figures 1A à 1D, la structure est divisée en bandes 54N et 54P. Dans la bande 54N, on dépose sur la couche 62 une couche 100 de masquage en nitrure de silicium. La couche 100 ne recouvre pas la bande 54P. On vient ensuite réaliser dans la bande 54P une épitaxie d'une couche 102 de silicium-germanium SiGe sur la couche 62. La couche 102 est le siège de contraintes de compression 104, ces contraintes ayant une composante longitudinale 104L et une composante transversale 104W. Ces contraintes sont dues au désaccord de maille cristalline entre le SiGe et le silicium de la couche 62. A titre d'exemple, la couche 102 de SiGe comprend entre 15 % et 40 % de germanium. L'épaisseur de la couche 102 de SiGe est par exemple comprise entre 5 et 10 nm.

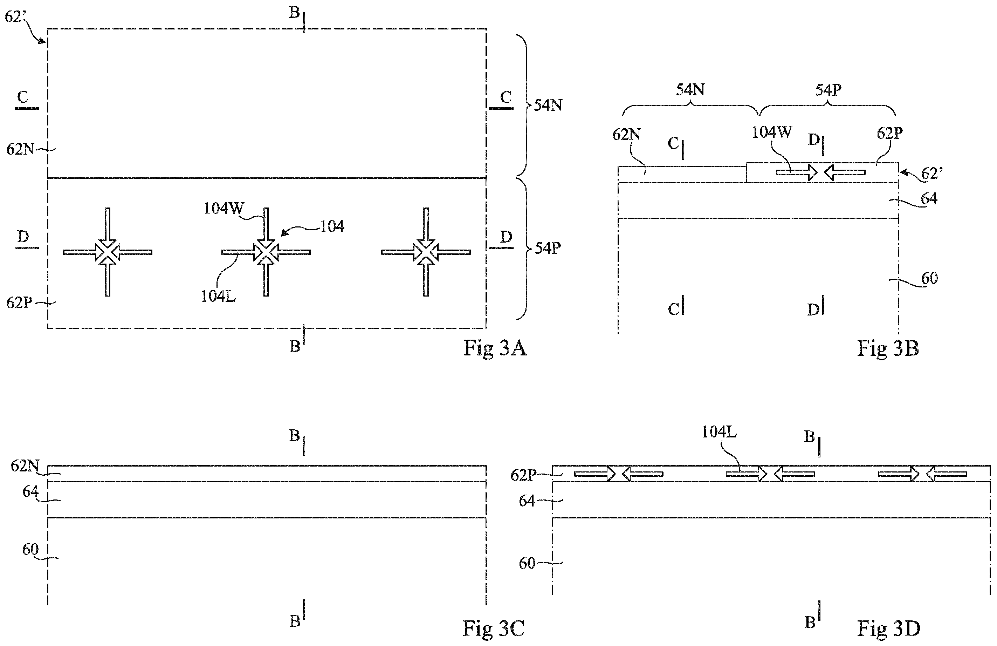

A l'étape des figures 3A à 3D, on réalise une oxydation thermique de la couche 102 de SiGe. Ceci transfère dans la couche de silicium 62 le germanium et les contraintes 104, et forme sur la couche 62 une couche d'oxyde que l'on retire ensuite. On retire aussi la couche de masquage 100. La couche semiconductrice 62' obtenue a, dans la bande 54N, une partie 62N en silicium et, dans la bande 54P, une partie 62P en SiGe contraint en compression transversale et longitudinale. Les contraintes 104 de la partie de la couche 62' en SiGe sont comprises par exemple entre 0,5 et 3 GPa.

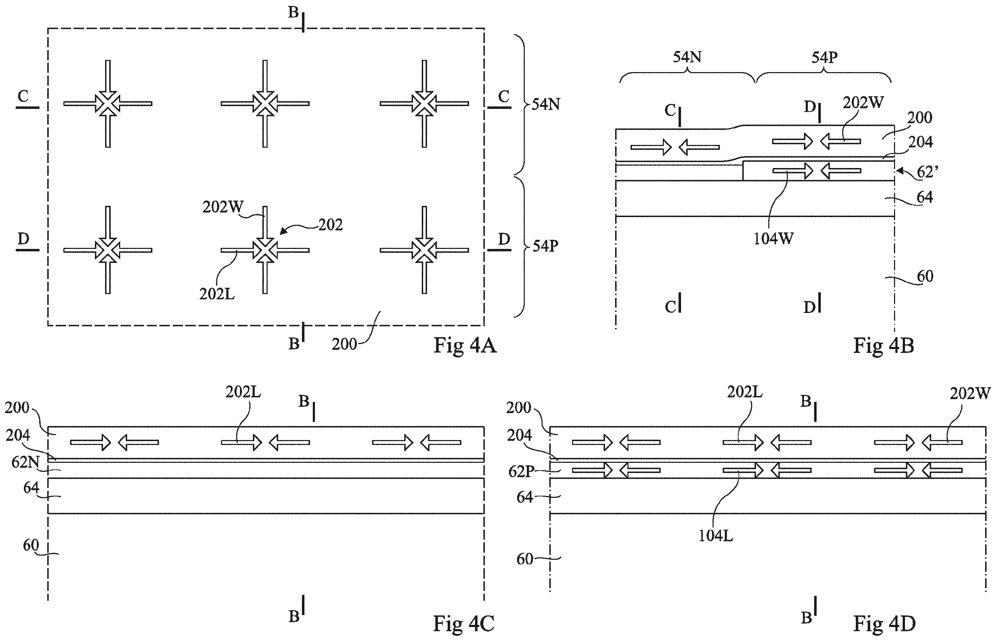

A l'étape des figures 4A à 4D, on forme une couche 200 de nitrure de silicium sur l'ensemble de la couche 62'. La couche 200 est par exemple formée par dépôt chimique en phase vapeur assisté par plasma PECVD (de l'anglais "Plasma-Enhanced Chemical Vapor Deposition"), en sorte d'obtenir des contraintes 202 de compression dans la couche 200. Ces contraintes ont une composante longitudinale 202L et une composante transversale 202W. A titre d'exemple, la couche 200 a une épaisseur comprise entre 20 et 100 nm. On prévoit de préférence, avant formation de la couche 200, de former une couche 204 d'oxyde sur l'ensemble de la couche 62'. L'épaisseur de la couche 204 est par exemple comprise entre 1 et 3 nm.

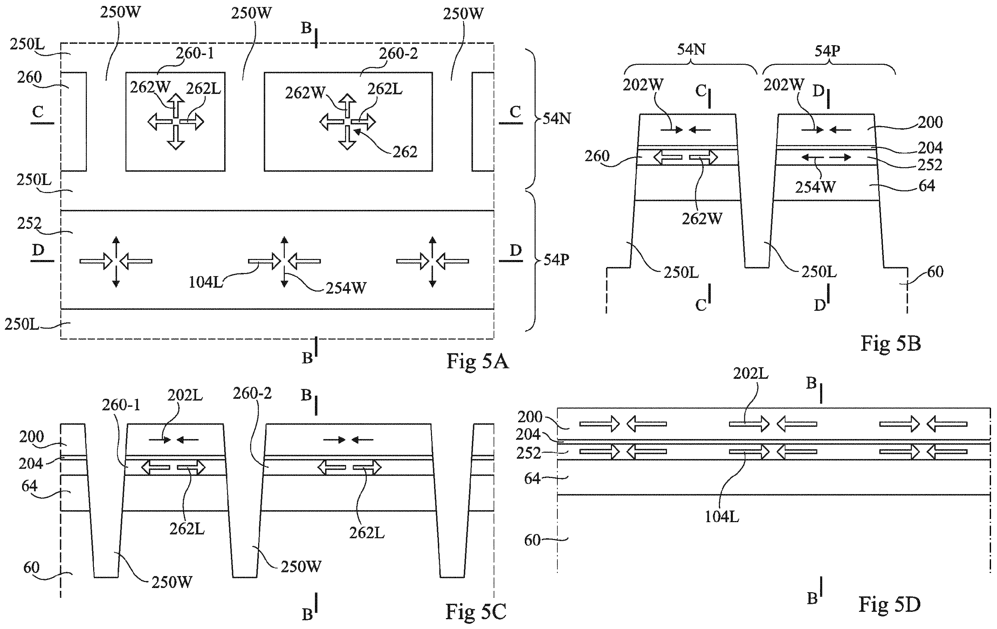

A l'étape des figures 5A à 5D, on grave des tranchées longitudinales 250L de part et d'autre des bandes 54N et 54P. On grave en outre des tranchées transversales 250W entre les tranchées 250L d'un bord à l'autre de la bande 54N. Les tranchées transversales 250W sont limitées à la seule bande 54N, et ne s'étendent pas jusqu'à la bande 54P, contrairement aux tranchées 70W de la puce de la figure 1. A partir de la face supérieure de la structure, les tranchées 250L et 250W traversent les couches 200 de nitrure de silicium contraint, la couche 204 éventuelle, la couche semiconductrice 62' et la couche isolante 64 sur toute leur épaisseur, et pénètrent dans le substrat 60.

Dans la bande 54P, du fait que les tranchées transversales ne s'étendent pas dans la bande 54P, on a laissé intact un ruban 252 de la couche 62'. Dans ce ruban, les contraintes de compression longitudinale 104L initialement présentes dans la couche 62' ne sont pas modifiées par la gravure. Du fait de la présence des tranchées longitudinales de part et d'autre de la bande 54P, les contraintes de compression transversale 104W se relâchent. En outre, dans la couche 200, les contraintes de compression transversales 202W se relâchent par un élargissement de la couche 200. Cet élargissement étire le ruban 252 transversalement, ce qui aide à relâcher les contraintes 104W en compression transversale, voire peut créer des contraintes 254W en tension transversale dans le ruban 252.

Dans la bande 54N, on a ainsi formé à partir de la couche semiconductrice 62' des dalles semiconductrices 260 entourées par les tranchées 250L et 250P. On a représenté une dalle 260-1 destinée à la réalisation d'un transistor, et une dalle 260-2 destinée à la réalisation de deux transistors. Du fait que les tranchées entourent chacune des dalles 260, on a créé des contraintes 262 en tension transversale 262W et en tension longitudinale 262L dans chacune des dalles. En effet, sur chacune des dalles 260, les contraintes en compression transversale 202W et longitudinale 202L se relâchent par un allongement transversal et longitudinal de la couche 200. Cet allongement étire la dalle 260 dans les directions transversale et longitudinale.

A titre d'exemple, les dalles 260 et la bande 252 ont des dimensions transversales inférieures à 1 µm. Les dalles ont par exemple des dimensions longitudinales inférieures à 1 µm. Les tranchées ont par exemple une profondeur comprise entre 100 et 300 nm.

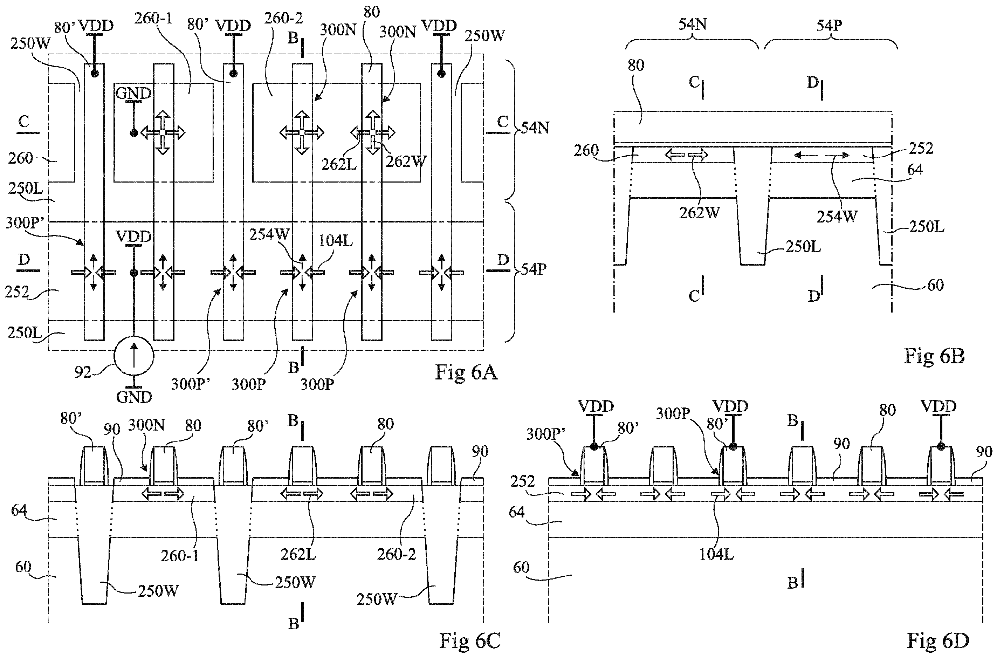

A l'étape des figures 6A à 6D, on effectue d'abord un traitement thermique de relaxation de la couche 200 de nitrure de silicium. La température et la durée du traitement thermique sont prévues en sorte de supprimer les contraintes de la couche 200, et ainsi transférer la déformation de la couche 200 et générer des contraintes en tension 262L, 262W dans les dalles 260, et 254W dans le ruban 252, tout en maintenant au moins une partie des contraintes 104L dans le ruban 252. Ceci est rendu possible par le fluage de la couche 64 en oxyde de silicium sous les dalles et par le fait que les tranchées traversent la couche 200. A titre d'exemple, le traitement thermique est effectué à une température comprise entre 1000°C et 1200°C pendant une durée comprise entre 1 et 30 min.

Après le traitement thermique, on retire les restes de la couche 200. Du fait que la couche 200 est fortement relaxée, ce retrait a peu d'effet sur les contraintes 104L et 254W du ruban 252 et sur les contraintes 262L et 262W des dalles 260. Par ailleurs, on remplit les tranchées 250L et 250W d'un isolant, par exemple d'oxyde de silicium.

On réalise ensuite les transistors. Pour cela, on forme des structures de grille isolée 80, s'étendant dans la direction transversale sur les deux bandes 54N et 54P et se répétant longitudinalement à un pas régulier. A titre d'exemple, les positions des tranchées transversales 250W sont prévues pour que certaines 80' des structures de grille 80, se situent sur ces tranchées entre les dalles 260 et soient sans contact avec les dalles. Dans la bande 54P, les structures de grille 80' sont situées sur le ruban 252. Chacune des autres structures de grille constitue les deux grilles connectées entre elles d'un transistor 300N et d'un transistor 300P en regard l'un de l'autre. A titre d'exemple, on prévoit des régions de drain-source 90 épitaxiées sur les dalles 260 et sur le ruban 252 de part et d'autre des grilles.

Du fait que l'on a gravé les tranchées transversales 250W, les transistors 300N sont à canal N contraint en tension longitudinale. Du fait que l'on a laissé en place les portions du ruban semiconducteur contraint situées dans l'alignement des tranchées transversales 250W, les transistors 300P sont à canal P contraint en compression longitudinale.

On forme ensuite des circuits non représentés similaires à ceux décrits en relation avec la figure 1. Dans l'exemple de la structure représentée, on forme un circuit comprenant le transistor 300N de la dalle 260-1 et le transistor 300P en regard, et un circuit voisin comprenant les deux transistors 300N de la dalle 206-2 et les deux transistors 300P en regard. En particulier, on relie, d'une manière représentée en figure 6A pour l'un des circuits, les sources des transistors 300N à la masse GND et les sources des transistors 300P à un noeud d'application du potentiel VDD fourni par une source d'alimentation 92.

On connecte les structures de grille 80' à un noeud d'application du potentiel VDD, ou, à titre de variante, d'un potentiel supérieur au potentiel VDD. Ceci permet d'isoler entre eux les circuits voisins, en bloquant les transistors 300P' formés par les grilles 80' sur le ruban 252.

Selon un avantage, du fait que les circuits obtenus comprennent des transistors à canal N contraint en tension longitudinale et des transistors à canal P contraint en compression longitudinale, ces circuits sont particulièrement rapides.

### Deuxième mode de réalisation

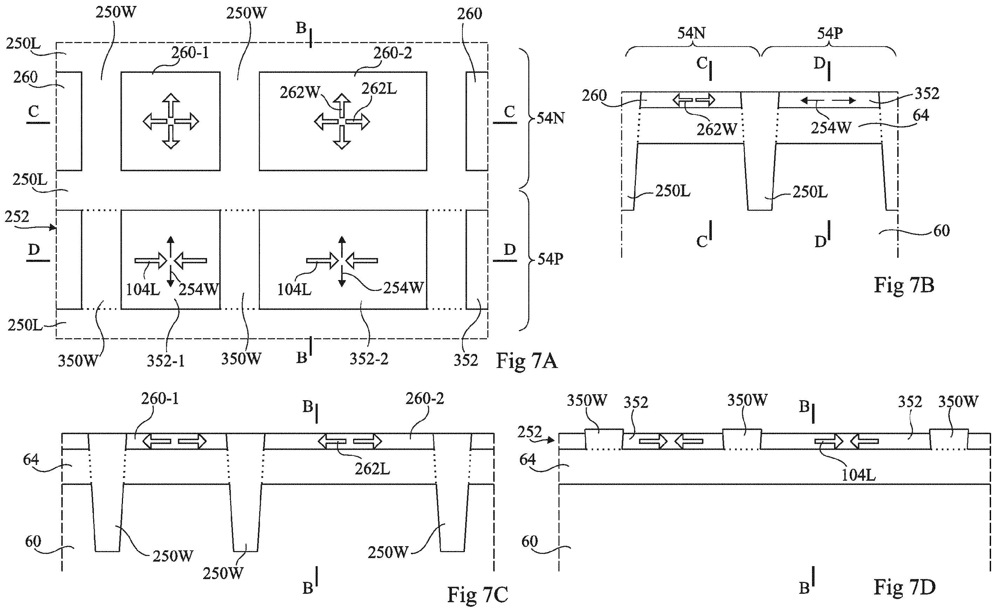

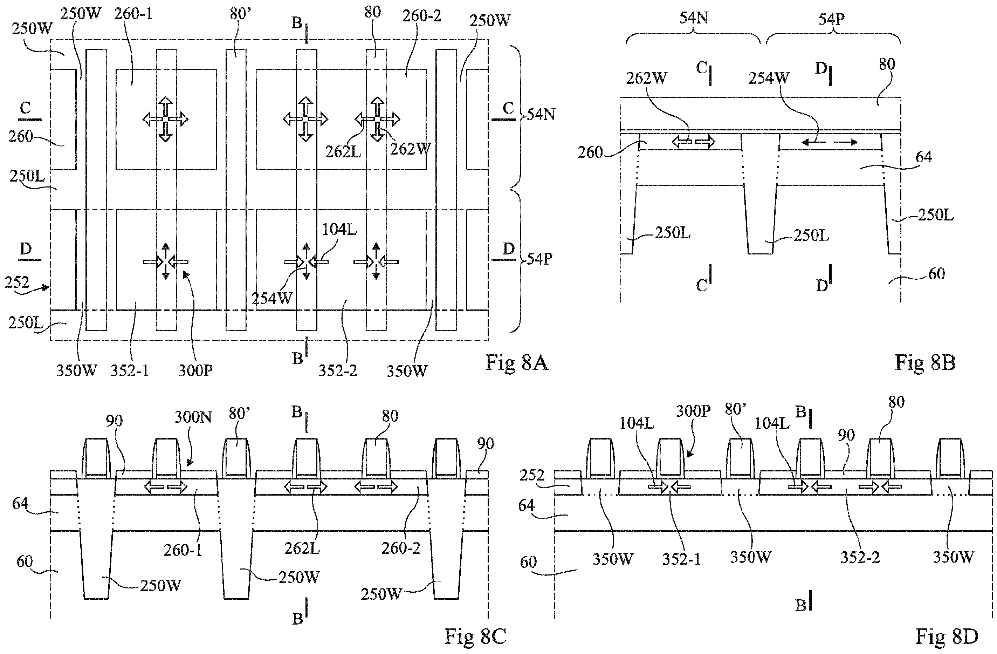

Les figures 7A à 7D et 8A à 8D illustrent schématiquement des étapes d'un deuxième mode de réalisation d'un procédé de fabrication simultanée de transistors à canal N contraint et à canal P contraint.

A l'étape des figures 7A à 7D, on a d'abord mis en oeuvre les étapes :
- des figures 2A à 2D et 3A à 3D, de formation d'une partie 62P en SiGe dans la couche semiconductrice 62 d'une structure SOI ;
- des figures 4A à 4D, de formation d'une couche contrainte 200 sur la couche semiconductrice ; et
- des figures 5A à 5D, de gravure des tranchées.

On a effectué le traitement thermique de relaxation, on a retiré les restes la couche 200 et on a rempli les tranchées 250L et 250W, d'une manière similaire à celle décrite en relation avec les figures 6A à 6D.

On oxyde ensuite thermiquement les portions du ruban 252 situées en regard des tranchées transversales 250W, c'est-à-dire dans l'alignement des tranchées transversales, sur toute la largeur et toute l'épaisseur du ruban 252. Il en résulte des barres transversales 350W d'oxyde thermique dans le ruban 252.

Du fait qu'au cours de l'oxydation, les portions concernées du ruban 252 n'ont pas été gravées et sont restées en place, on n'a pas créé de bords libres dans le ruban et les contraintes de compression longitudinale 104L initialement présentes dans le ruban sont maintenues. Le ruban 252 comprend des portions 352 en SiGe en compression longitudinale 104L entre les barres 350W, ces portions 352 étant situées en regard des dalles 260. A titre d'illustration, on a représenté une portion 352-1 en regard de la dalle 260-1 et une portion 352-2 en regard de la dalle 260-2. En outre, l'oxydation thermique ne modifie pas les contraintes transversales 254W du ruban 252, ni les contraintes 262L et 262W dans les dalles 260 de la bande 54N.

A l'étape des figures 8A à 8B, on réalise les transistors et les circuits (non représentés) d'une manière similaire à celle décrite en relation avec les figures 6A à 6D, à la différence que l'on ne relie pas forcément les grilles 80' à un noeud d'application du potentiel VDD ou d'un potentiel supérieur au potentiel VDD. On obtient une structure similaire à celle illustrée en figures 6A à 6D, à la différence que, dans le ruban 54P, les structures de grille 80' sont situées sur les barres d'oxyde 350W.

Dans la structure ainsi obtenue, les circuits voisins, c'est-à-dire, dans l'exemple illustré, un circuit comprenant les transistors des dalles 260-1 et 352-1 et un circuit comprenant les transistors des dalles 260-2 et 352-2, sont isolés entre eux, dans la bande 54P, par les barres 350W, et, dans la bande 54N, par les tranchées 250W. On conserve l'avantage de circuits particulièrement rapides.

### Troisième mode de réalisation, non revendiqué

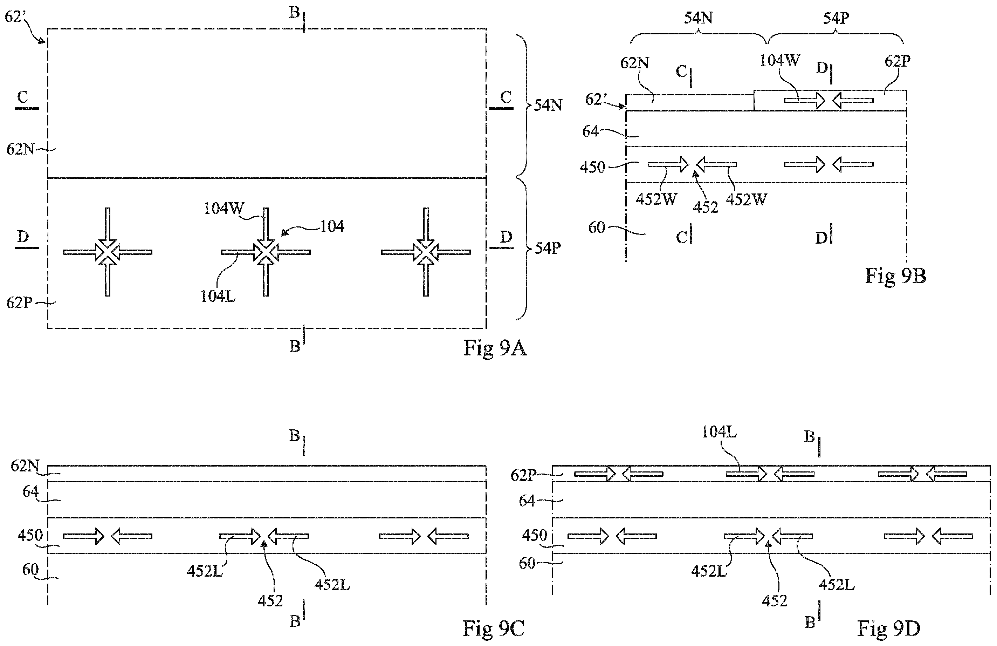

Les figures 9A à 9D, 10A à 10D et 11A à 11D illustrent schématiquement des étapes d'un troisième mode de réalisation d'un procédé de fabrication simultanée de transistors à canal N et à canal P contraints différemment.

A l'étape des figures 9A et 9B, on a mis en oeuvre des étapes similaires à celles des figures 2A à 2D et 3A à 3D de formation d'une partie en SiGe contraint dans la couche semiconductrice d'une structure SOI, à la différence que l'on a prévu au préalable, dans la structure SOI, une couche 450 de SiGe contraint situé sur un substrat 60 en silicium. L'ensemble de la couche conductrice 62 sur la couche isolante 64 est alors situé sur la couche de SiGe 450.

Une telle structure SOI à couche SiGe contrainte enterrée peut être obtenue de la manière suivante. On épitaxie d'abord du SiGe sur le substrat. Il résulte de cette épitaxie des contraintes en compression 452, longitudinale 452L et transversale 452W, en raison du désaccord de maille cristalline entre le silicium du substrat et le SiGe. On réalise ensuite, sur la couche contrainte 450, l'ensemble de la couche semiconductrice 62 sur la couche isolante 64, d'une manière connue similaire à celle mise en oeuvre pour obtenir une structure SOI sur un substrat non recouvert d'une couche contrainte. A titre d'exemple, la couche 450 comprend entre 20 et 60 % de germanium. Les contraintes 452 obtenues sont par exemple comprises entre 1,3 et 3,5 GPa. La couche 450 peut avoir une épaisseur par exemple comprise entre 10 et 40 nm. Les épaisseurs des couches isolante et semiconductrice sont par exemple les mêmes que celles du premier mode de réalisation.

Ainsi, la structure obtenue à l'étape des figures 9A à 9D comprend, sous la couche isolante, la couche contrainte 450, et sur la couche isolante, une couche semiconductrice 62'. La couche 62' correspond à celle obtenue à l'étape des figures 3A à 3D, à savoir qu'elle comprend, dans la bande 54N, une partie 62N en silicium, et, dans la bande 54P, une partie 62P en SiGe soumise à des contraintes de compression 104, longitudinale 104L et transversale 104W.

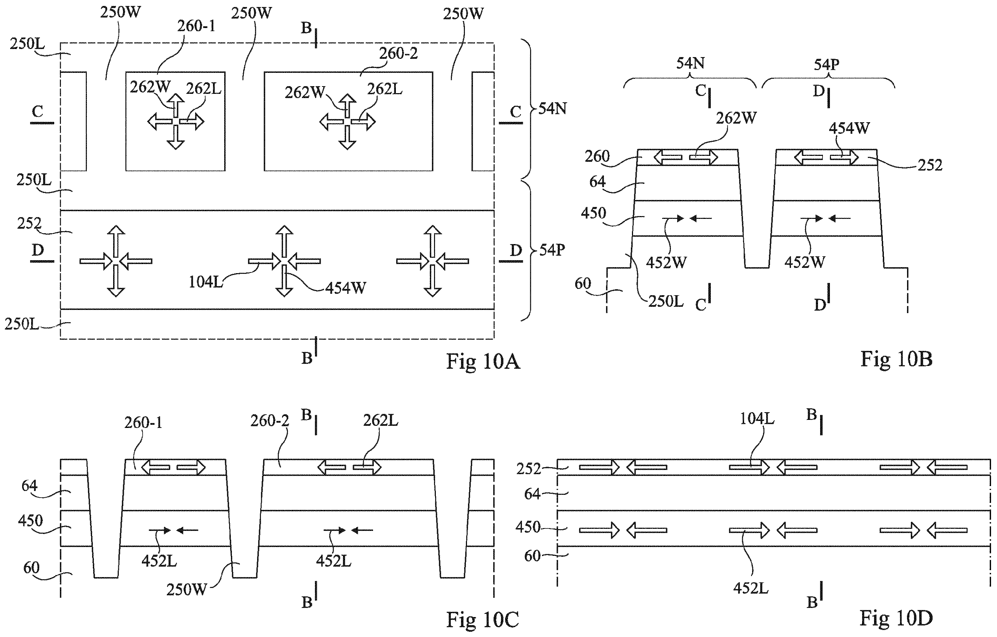

A l'étape des figures 10A à 10D, on grave des tranchées 250W et 250L similaires aux tranchées gravées à l'étape des figures 5A à 5D, en particulier, les tranchées transversales 250W sont limitées à la seule bande 54N, et ne s'étendent pas jusqu'à la bande 54P. Les tranchées 250W et 250L traversent de part en part les couches semiconductrice 62', isolante 64, contrainte 450, et pénètrent dans le substrat 60.

Dans la bande 54P, on a formé, comme dans le premier mode de réalisation, un ruban 252 soumis aux contraintes de compression longitudinale 104L. Du fait de la présence des tranchées longitudinales de part et d'autre de la bande 54P, les contraintes de compression transversale 104W sont relâchées. En outre, dans la couche 450, les contraintes de compression transversales 452W sont relâchées, et ce relâchement est accompagné d'un élargissement de la couche 450. Ceci étire le ruban 252 transversalement et y crée des contraintes 454W en tension transversale. Ceci est permis par le fait que la couche 450 de SiGe contraint enterré a une épaisseur et une concentration en germanium supérieures à celles de la partie 62P de la couche 62'. A titre d'exemple, les contraintes 454W sont supérieures à 0,5 GPa. Par ailleurs, on note que, dans la bande 54P, les contraintes de compression longitudinale 452L de la couche contrainte enterrée 450 ne sont pas relâchées.

Dans la bande 54N, on a obtenu, comme dans le premier mode de réalisation, des dalles semiconductrices 260 entourées par les tranchées 250L et 250W. Ces dalles sont soumises à des contraintes 262 en tension transversale 262W et longitudinale 262L. Les contraintes 452 de la couche 450 sont en partie relâchées dans la bande 54N.

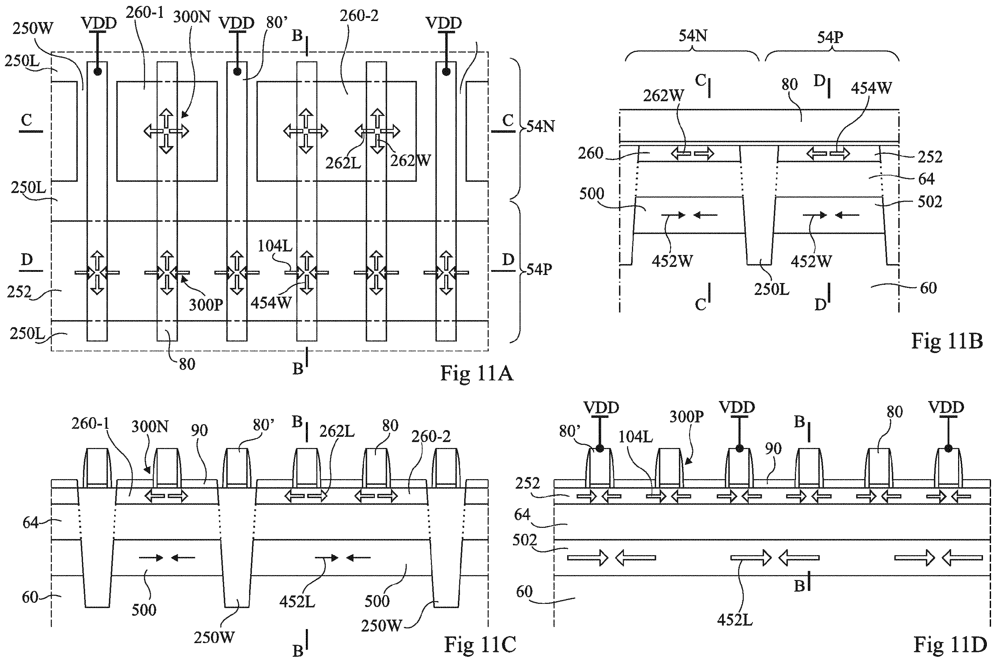

A l'étape des figures 11A à 11D, on procède au remplissage des tranchées, à la formation des transistors, et à la formation des circuits (non représentés) de la manière décrite en relation avec les figures 6A à 6D. On obtient une structure similaire à celle des figures 6A à 6D, à la différence que les transistors 300P sont soumis aux contraintes en tension transversale 454W et que la couche enterrée 450 reste présente sous la couche isolante 64. Cette couche 450 est, dans la bande 54N, sous forme d'une dalle 500 sous chaque dalle 260, et, dans la bande 54P, sous forme d'un ruban 502 contraint longitudinalement (contraintes 452L) sous le ruban 252.

Selon un avantage, les transistors 300P obtenus sont particulièrement rapides, du fait qu'ils sont à canal P contraint à la fois en forte compression longitudinale et en forte tension transversale. Les circuits obtenus sont donc particulièrement rapides.

### Quatrième mode de réalisation, non revendiqué

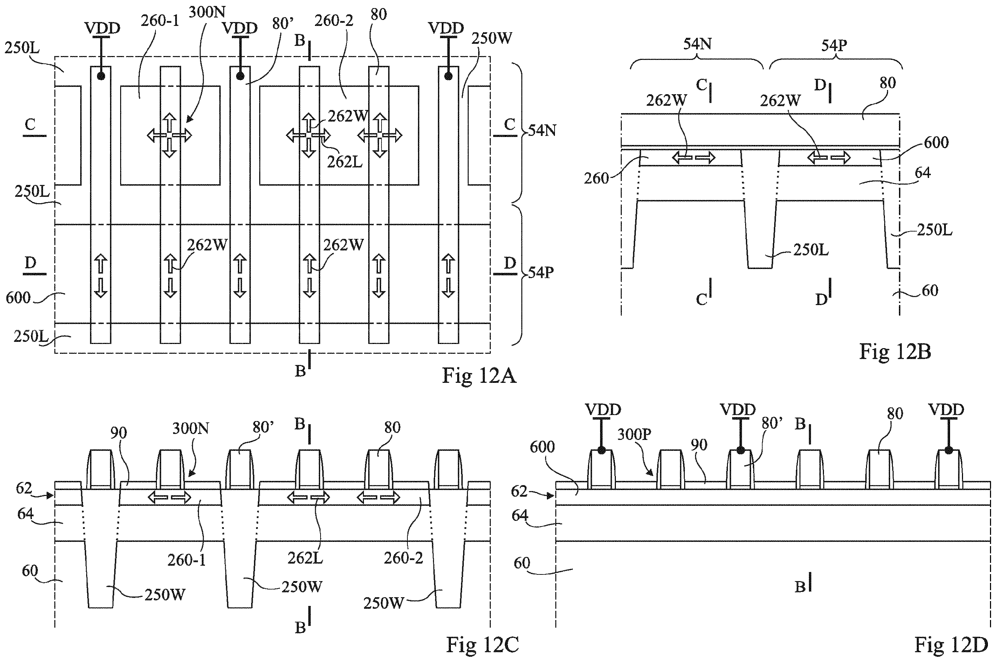

Les figures 12A à 12D illustrent schématiquement une étape finale d'un quatrième mode de réalisation d'un procédé de fabrication simultanée de transistors à canal N et à canal P contraints différemment.

On a prévu une structure SOI du type de celle prévue au début de l'étape des figures 2A à 2D, à savoir, sur un substrat 60, l'ensemble d'une couche 62 de silicium sur une couche isolante 64. On met alors en oeuvre les étapes :
- des figures 4A à 4D, de formation d'une couche contrainte de nitrure de silicium ;
- des figures 5A à 5D, de formation des tranchées ; et
- des figures 6A à 6D, de traitement thermique de relaxation, de remplissage des tranchées, de retrait de la couche contrainte, de formation des transistors,
dans lesquelles la couche 62', dont on a vu qu'elle est en deux parties 62N et 62P différentes dans les rubans 54N et 54P, est remplacée par la couche 62 partout en silicium.

On obtient une structure similaire à celle des figures 6A à 6D, à la différence que, dans la bande 54P, le ruban 252 est remplacé par un ruban 600. Le ruban 600 n'est pas soumis à des contraintes longitudinales, et est soumis à des contraintes transversales 262W similaires à celles des dalles 260. On obtient donc des transistors à canal N contraint en tension longitudinale, et des transistors à canal P contraint en tension transversale, ce qui permet des circuits particulièrement rapides.

A titre de variante de ce mode de réalisation, on peut remplacer les connexions au potentiel VDD des structures de grille 80' par toute structure permettant d'isoler les circuits entre eux, en particulier par des barres d'oxyde obtenues de la manière décrite en relation avec les figures 7A à 7D.

### Cinquième mode de réalisation, non revendiqué

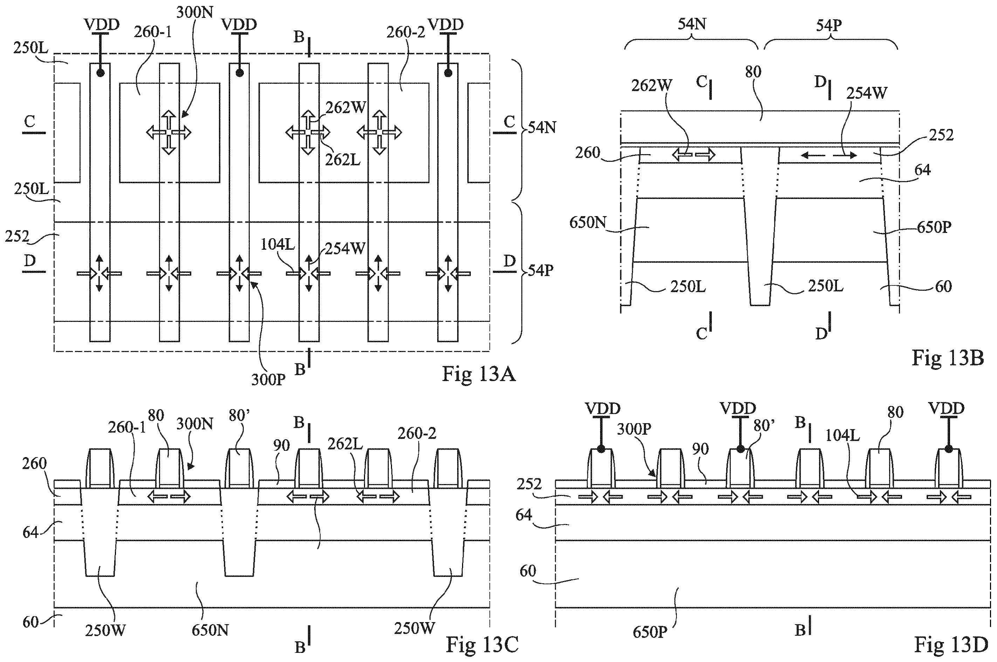

Les figures 13A à 13D illustrent schématiquement une étape finale d'un cinquième mode de réalisation d'un procédé de fabrication simultanée de transistors à canal N contraint et à canal P contraint.

Le cinquième mode de réalisation est similaire au premier mode de réalisation, à la différence qu'on prévoit, par exemple avant de former les tranchées 250W et 250L, une étape de formation de caissons dopés 650N et 650P, et que l'on met en oeuvre une variante de l'étape des figures 5A à 5D de gravure des tranchées.

Les caissons 650N et 650P sont situés dans le substrat semiconducteur 60 sous la couche isolante 64, respectivement dans les bandes 54N et 54P. Les caissons 650N et 650P permettent d'obtenir divers effets sur les transistors en fonctionnement, par exemple permettent d'ajuster leurs tensions de seuil afin de jouer sur leur rapidité ou sur leur courant de fuite à l'état bloqué. Les types et niveaux de dopage des caissons 650N et 650P dépendent des effets que l'on souhaite obtenir.

A l'étape de gravure de tranchées, les tranchées longitudinales 250L s'étendent plus profondément que les caissons et pénètrent dans le substrat sous les caissons 650N et 650P. Les tranchées 250W s'arrêtent à une profondeur située dans le caisson 650N, inférieure à celle des tranchées 250L.

La structure obtenue dans ce cinquième mode de réalisation est similaire à celle des figures 6A à 6D, à la différence qu'elle comprend les caissons 650N et 650P et que les tranchées transversales et longitudinales ont les profondeurs décrites ci-dessus.

On assure, d'une part, la continuité électrique des caissons 650N et 650P, et, d'autre part, une isolation électrique entre les caissons 650N et 650P. On peut ensuite, par des contacts de polarisation non représentés, polariser ces caissons et agir différemment sur les transistors 300N et sur les transistors 300P.

### Généralisations

Des modes de réalisation particuliers ont été décrits. Diverses variantes et modifications apparaîtront à l'homme de l'art. En particulier, bien que les transistors à canal contraint obtenus par les modes de réalisation décrits soient situés dans deux bandes 54N et 54P côte à côte, il est possible d'obtenir de manière similaire des transistors à canal N contraint en tension longitudinale et à canal P contraint en tension transversale et/ou longitudinale, situés respectivement dans des bandes 54N et des bandes 54P parallèles alternées.

En outre, bien que l'on obtienne des paires de transistors en regard reliés par une structure de grille commune s'étendant à la fois sur la bande 54N et sur la bande 54P, on peut interrompre la structure de grille entre les bandes 54N et 54P, en sorte d'obtenir des paires d'un transistor à canal N et d'un transistor à canal P isolés l'un de l'autre. On pourra aussi donner aux structures de grille toute configuration permettant de réaliser des grilles connectées de transistors voisins.

De plus, les structures de grille 80' prévues dans le deuxième mode de réalisation peuvent être situées en bordure de dalle, à cheval entre la dalle 260 et la tranchée 250W.

D'autres modes de réalisation se basant en partie sur les cinq modes de réalisation expliqués précédemment peuvent être envisagés. Des exemples de tels autres modes de réalisation sont donnés ci-après.

Dans un sixième mode de réalisation, on part de la structure obtenue aux étapes 10A à 10D, de formation des tranchées du troisième mode de réalisation. On a vu que cette structure comprend une couche de SiGe enterrée. On forme alors des barres d'oxyde thermique 350W de la manière décrite en relation avec les figures 7A à 7D, puis on forme les transistors et les circuits. On obtient une structure similaire à celle des figures 11A à 11D du troisième mode de réalisation, à la différence que le ruban 252 comprend des barres 350W d'oxyde sous les grilles 80', les grilles 80' n'étant alors pas forcément reliées à un noeud d'application du potentiel VDD ou d'un potentiel supérieur au potentiel VDD.

Dans un septième mode de réalisation, non revendiqué, on a prévu une structure SOI à couche de SiGe contrainte enterrée, et on met en oeuvre les étapes des figures 10A à 10D de formation des tranchées, puis de formation des transistors et des circuits. On obtient une structure similaire à celle des figures 12A à 12D du quatrième mode de réalisation, à la différence que la couche enterrée est présente sous la couche isolante 64, cette couche enterrée étant contrainte longitudinalement dans la bande 54P.

Dans un huitième mode de réalisation, non revendiqué, on a prévu une structure SOI à couche de SiGe contrainte enterrée, puis on met en oeuvre les étapes des figures 10A à 10D de formation des tranchées, d'où il résulte en particulier, dans la bande 54P, un ruban 600 de silicium à la place du ruban 252 de SiGe. On forme ensuite des barres d'oxyde thermique de la manière décrite en relation avec les figures 7A à 7D, puis on forme les transistors et les circuits. On obtient une structure similaire à celle des figures 12A à 12D, à la différence, d'une part, que la couche enterrée est présente sous la couche isolante 64, et, d'autre part, que le ruban 600 comprend des barres d'oxyde de silicium sous les grilles 80'. Les grilles 80' ne sont alors pas forcément reliées à un noeud d'application du potentiel VDD ou d'un potentiel supérieur au potentiel VDD. A titre de variante, les grilles 80' peuvent être omises.

En outre, comme on l'a décrit ci-dessus, le cinquième mode de réalisation correspond au premier mode de réalisation dans lequel on a prévu une étape de formation de caissons, et dans lequel les tranchées longitudinales et transversales sont de profondeurs différentes. Dans tous les autres modes de réalisation, on peut, de la même manière, prévoir une étape de formation de caissons, puis prévoir que les tranchées longitudinales traversent les caissons, et que les tranchées transversales s'arrêtent dans les caissons.

Par ailleurs, on a décrit des modes de réalisation comprenant soit une couche contrainte 450 en SiGe enterrée sous l'ensemble de la couche semiconductrice 62 ou 62' sur la couche isolante 64, soit une couche contrainte 200 en nitrure de silicium déposée sur l'ensemble de la couche semiconductrice 62 ou 62' sur la couche isolante. D'autres modes de réalisation comprennent à la fois une couche contrainte en compression enterrée sous la couche isolante, et une couche contrainte en compression déposée sur la couche semiconductrice. Les tranchées traversent alors les deux couches contraintes.

## Revendications

1. Procédé de fabrication simultanée de transistors MOS à canal N (300N) et à canal P (300P) contraints différemment et situés respectivement dans des première (54N) et deuxième (54P) bandes côte à côte, le procédé comprenant les étapes suivantes :
a) prévoir, sur un substrat (60), une couche contrainte (200 ; 450) en compression (202 ; 452) sur ou sous l'ensemble d'une couche semiconductrice (62 ; 62') disposée sur une couche isolante (64) ;
b) graver au travers des couches contrainte, semiconductrice et isolante, et dans le substrat, des tranchées longitudinales (250L) entre les bandes et de part et d'autre des bandes ;
c) graver au travers des couches contrainte, semiconductrice et isolante de la première bande, et dans le substrat, des tranchées transversales (250W) s'étendant d'un bord à l'autre de la première bande et ne s'étendant pas dans la deuxième bande, d'où il résulte, dans la première bande entre les tranchées transversales, des dalles semiconductrices (260) contraintes en tension (262W, 262L), et, dans la deuxième bande, un ruban semiconducteur (252 ; 600) contraint en compression longitudinale (104L) ; et
d) former les transistors dans et sur les dalles et dans et sur les portions (352) du ruban en regard des dalles,
le procédé comprenant :
à l'étape d), oxyder thermiquement les portions (350W) du ruban (252) en regard des tranchées transversales (250W) sur toute l'épaisseur du ruban ; et
à l'étape a) :
prévoir une couche de silicium (62) sur la couche isolante ;
épitaxier dans la deuxième bande (54P) une couche de silicium-germanium sur la couche de silicium ; et
oxyder thermiquement la structure dans la deuxième bande,
d'où il résulte que ladite couche semiconductrice est en silicium dans la première bande (54N) et en silicium-germanium dans la deuxième bande (54P).

2. Procédé selon la revendication 1, comprenant :
à l'étape d), former des grilles isolées (80') sur les portions du ruban oxydées (350W) en regard des tranchées transversales (250W) ;
relier les transistors (300N, 300P) à une source (92) de potentiels haut (VDD) et bas (GND) d'alimentation ; et
relier lesdites grilles isolées à un noeud d'application du potentiel haut d'alimentation.

3. Procédé selon la revendication 1 ou 2, dans lequel la couche isolante (64) est en oxyde de silicium, et la couche contrainte (200) est en nitrure de silicium formé à l'étape a) par dépôt chimique en phase vapeur assisté par plasma, le procédé comprenant, après les étapes b) et c) :
effectuer un traitement thermique de relaxation de la couche contrainte adapté à conserver au moins en partie les contraintes (104L, 262) du ruban (252) et des dalles (260) ; et
retirer la couche contrainte.

4. Procédé selon la revendication 1 ou 2, dans lequel :
le substrat (60) est en silicium ; et
la couche contrainte (450) est en silicium-germanium et est épitaxiée à l'étape a) sur le substrat avant de former l'ensemble des couches isolante (64) et semiconductrice (62 ; 62') sur la couche contrainte.

5. Procédé selon l'une quelconque des revendications 1 à 4, dans lequel les étapes b) et c) sont réalisées simultanément et les tranchées transversales (250W) et longitudinales (250L) ont la même profondeur.

6. Procédé selon l'une quelconque des revendications 1 à 4, comprenant une étape de formation d'un caisson (650N) semiconducteur dopé sous la couche isolante (64) dans la première bande (54N), les tranchées longitudinales (250L) s'étendant plus profondément que le caisson, et les tranchées transversales (250W) s'étendant jusqu'à un niveau situé dans le caisson.

## Patentansprüche

1. Ein Verfahren zum gleichzeitigen Herstellen von N-Kanal- (300N) und P-Kanal- (300P) MOS-Transistoren, die unterschiedlich verspannt sind und sich jeweils in einem ersten (54N) und einem zweiten (54P) nebeneinanderliegenden Streifen befinden, wobei das Verfahren die folgenden Schritte aufweist:
a) Bereitstellen, auf einem Substrat (60), einer Schicht (200; 450), die unter oder über der Anordnung einer Halbleiterschicht (62; 62') kompressiv verspannt ist (202; 452), die auf einer Isolierschicht (64) angeordnet ist;
b) Ätzen durch die verspannten Halbleiter- und Isolierschichten und in das Substrat von Längsgräben (250L) zwischen den Streifen und auf beiden Seiten der Streifen;
c) Ätzen durch die verspannten Halbleiter- und Isolierschichten des ersten Streifens und in das Substrat von querverlaufenden Gräben (250W), die sich von einer Kante zur anderen des ersten Streifens erstrecken und sich nicht in den zweiten Streifen hinein erstrecken,
was im ersten Streifen zwischen den querverlaufenden Gräben zu zugverspannten (262W, 262L) Halbleiterscheiben (260) und im zweiten Streifen zu einem Halbleiterband (252; 600) führt, das in Längsrichtung (104L) kompressiv verspannt ist; und
d) Ausbilden der Transistoren innerhalb und auf den Scheiben und innerhalb und auf den Bandabschnitten (352) gegenüber den Scheiben, wobei das Verfahren Folgendes aufweist:
in Schritt d) thermisches Oxidieren der Abschnitte (350W) des Bandes (252) gegenüber den querverlaufenden Gräben (250W) über die gesamte Banddicke; und
in Schritt a):
Bereitstellen einer Siliziumschicht (62) auf der Isolierschicht;
epitaxiales Aufwachsen in dem zweiten Streifen (54P) einer Silizium-Germanium-Schicht auf der Siliziumschicht; und
thermisches Oxidieren der Struktur in dem zweiten Streifen,
wobei die Halbleiterschicht in dem ersten Streifen (54N) aus Silizium und in dem zweiten Streifen (54P) aus Silizium-Germanium besteht.

2. Das Verfahren nach Anspruch 1, das Folgendes aufweist:
in Schritt d) Ausbilden von isolierten Gates (80') auf den oxidierten Bandabschnitten gegenüber den querverlaufenden Gräben (250W);
Verbinden der Transistoren (300N, 300P) mit einer Quelle (92) mit hohem (VDD) und niedrigem (GND) Versorgungspotential; und
Verbinden der isolierten Gates mit einem Knotenpunkt, an dem das hohe Versorgungspotential angelegt wird.

3. Das Verfahren nach Anspruch 1 oder 2, wobei die Isolierschicht (64) aus Siliziumoxid besteht und die verspannte Schicht (200) aus Siliziumnitrid besteht, das in Schritt a) durch plasmaunterstützte chemische Gasphasenabscheidung gebildet wird, wobei das Verfahren nach den Schritten b) und c) Folgendes aufweist:
Durchführen einer thermischen Behandlung zur Entspannung der verspannten Schicht, die in der Lage ist, die Spannung (104L, 262) des Bandes (252) und der Scheiben (260) zumindest teilweise aufrechtzuerhalten; und
Entfernen der verspannten Schicht.

4. Das Verfahren nach Anspruch 1 oder 2, wobei:
das Substrat (60) aus Silizium gebildet ist; und
die verspannte Schicht (450) aus Silizium-Germanium gebildet ist und in Schritt a) auf dem Substrat durch Epitaxie aufgewachsen ist, bevor die Anordnung aus der isolierenden Schicht (64) und der Halbleiterschicht (62; 62') auf der verspannten Schicht gebildet wird.

5. Das Verfahren nach einem der Ansprüche 1 bis 4, wobei die Schritte b) und c) gleichzeitig ausgebildet werden und die quer verlaufenden (250W) und längs verlaufenden (250L) Gräben die gleiche Tiefe aufweisen.

6. Das Verfahren nach einem der Ansprüche 1 bis 4, aufweisend einen Schritt des Ausbildens einer dotierten Halbleiter-Wanne (650N) unter der Isolierschicht (64) in dem ersten Streifen (54N), wobei sich die Längsgräben (250L) tiefer als die Wanne erstrecken und sich die querverlaufenden Gräben (250W) bis zu einer Ebene erstrecken, die sich in der Wanne befindet.

## Claims

1. A method of simultaneously manufacturing N-channel (300N) and P-channel (300P) MOS transistors strained differently and respectively located in first (54N) and second (54P) side-by-side strips, the method comprising the steps of:
a) providing, on a substrate (60), a layer (200; 450) compressively strained (202; 452) under or over the assembly of a semiconductor layer (62; 62') arranged on an insulating layer (64);
b) etching through the strained, semiconductor, and insulating layers, and in the substrate, longitudinal trenches (250L) between the strips and on either side of the strips;
c) etching through the strained, semiconductor, and insulating layers of the first strip, and in the substrate, transverse trenches (250W) extending from one edge to the other of the first strip and not extending in the second strip,
which results, in the first strip between the transverse trenches, in tensilely strained (262W, 262L) semiconductor slabs (260) and, in the second strip, in a semiconductor band (252; 600) compressively strained in the longitudinal direction (104L); and
d) forming the transistors inside and on top of the slabs and inside and on top of the band portions (352) opposite the slabs,
the method comprising:
at step d), thermally oxidizing the portions (350W) of the band (252) opposite the transverse trenches (250W) all across the band thickness; and
at step a):
providing a silicon layer (62) on the insulating layer;
epitaxially growing in the second strip (54P) a silicon-germanium layer on the silicon layer; and
thermally oxidizing the structure in the second strip,
whereby said semiconductor layer is made of silicon in the first strip (54N) and of silicon-germanium in the second strip (54P).

2. The method of claim 1, comprising:
at step d), forming insulated gates (80') on the oxidated band portions opposite the transverse trenches (250W);
connecting the transistors (300N, 300P) to a source (92) of high (VDD) and low (GND) power supply potentials; and
connecting said insulated gates to a node of application of the high power supply potential.

3. The method of claim 1 or 2, wherein the insulating layer (64) is made of silicon oxide and the strained layer (200) is made of silicon nitride formed at step a) by plasma-enhanced chemical vapor deposition, the method comprising, after steps b) and c):
performing a thermal treatment of relaxation of the strained layer capable of at least partly keeping the strain (104L, 262) of the band (252) and of the slabs (260); and
removing the strained layer.

4. The method of claim 1 or 2, wherein:
the substrate (60) is made of silicon; and
the strained layer (450) is made of silicon-germanium and is grown by epitaxy at step a) on the substrate before forming the assembly of the insulating (64) and semiconductor (62; 62') layers on the strained layer.

5. The method of any of claims 1 to 4, wherein steps b) and c) are formed simultaneously and the transverse (250W) and longitudinal (250L) trenches have the same depth.

6. The method of any of claims 1 to 4, comprising a step of forming a doped semiconductor well (650N) under the insulating layer (64) in the first strip (54N), the longitudinal trenches (250L) extending deeper than the well, and the transverse trenches (250W) extending all the way to a level located in the well.
